# EUROPEAN PATENT APPLICATION

(11) **EP 2 913 856 A1**
(43) Date of publication of application: **02.09.2015**
(21) Application number: 13849159.2
(22) Date of filing: 02.08.2013
(51) Int. Cl.: H01L 33/62, H01L 23/36, H01L 33/60, H01L 33/64

(54) **LIGHT EMITTING DEVICE, METHOD FOR MANUFACTURING SAME, AND BODY HAVING LIGHT EMITTING DEVICE MOUNTED THEREON**

(30) Priority: 25.10.2012 JP 2012235379
(71) Applicant: Panasonic Intellectual Property Management Co., Ltd., Osaka-shi, Osaka 540-6207 (JP)
(72) Inventor: TOMITA, Yoshihiro, (JP); SAWADA, Susumu, (JP); NAKATANI, Seiichi, (JP); KAWAKITA, Koji, (JP); YAMASHITA, Yoshihisa, (JP)
(74) Representative: Eisenführ Speiser
(86) International application number: PCT/JP2013/004707
(87) International publication number: WO 2014/064871

(57) **Abstract**

There is provided a light-emitting device comprising a light-emitting element, an element electrode, an extending-wiring electrode and a support. In the light-emitting device of the present invention, the light-emitting element is supported and secured by the support in such a form that a principal surface of the support and an active surface of the light-emitting element are approximately flush with each other. Further, the extending-wiring electrode is in a surface contact with the element electrode such that the extending-wiring electrode extends beyond a periphery of the light-emitting element to the principal surface of the support, wholly covering the active surface of the light-emitting element.

## Description

### TECHNICAL FIELD

The present invention relates to a light-emitting device, a method for manufacturing the light-emitting device, and a package. More particularly, the present invention relates to a light-emitting device equipped with a light-emitting diode (which is referred to also as "LED" hereinafter), a package using such device, and also a method for manufacturing such device.

### BACKGROUND OF THE INVENTION

A LED, which serves as a light source, has been used in various applications because it is considered as being energy-saving and having a long lifetime. For example, the LED has been recently used as a backlight source for display device (e.g., liquid crystal display), and also used for a camera flash applications. Furthermore the LED is used for various types of lighting applications, special lighting applications and automotive light applications. These applications generally require a high brightness.

The high brightness of the LED is based on a luminous efficiency and a light extraction in that an electricity applied to the LED chip is efficiently extracted as a light, which however involves a lot of problems. For example, the high brightness of the LED is generally achieved by an increase in the current applied to the LED so as to increase the amount of light. The increased current applied to the LED, however, can cause a lower luminous efficiency due to a concentrated current density, and also can cause the performance of the LED chip to be degraded due to the increased amount of heat generation.

### PATENT DOCUMENTS (PRIOR ART PATENT DOCUMENTS)

PATENT DOCUMENT 1: JP2009-129928
PATENT DOCUMENT 2: WO08/088165

### DISCLOSURE OF THE INVENTION

### PROBLEMS TO BE SOLVED BY THE INVENTION

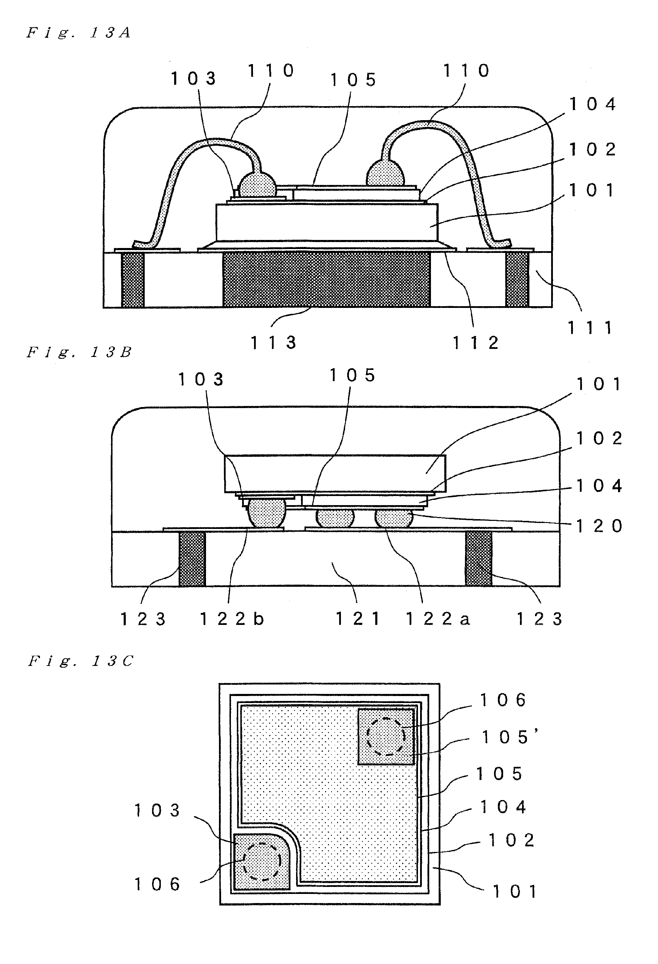

The package form of the currently-used LED chip can be classified into two types of "Wire Bonding type (W/B type)" and "Flip Chip type (F/C type)". According to the "Wire Bonding type (W/B type)", an electrode of the LED chip faces upward, and a gold wire is in connection to the upward electrode, and thereby ensuring an electrical connection of the LED chip (see Fig. 13A). While on the other hand, according to the "Flip-Chip type (F/C type)", an electrode of the LED chip faces downward, and a gold bump is in connection to the downward electrode, and thereby ensuring an electrical connection of the LED chip (see Fig. 13B). The LED chip in itself has such a form as shown in Fig. 13C. Specifically, a cathode electrode 103 is provided as an electrode film on a part of n-type layer 102 formed on a LED substrate 101. While on the other hand, an anode electrode 105 is provided as an electrode film on light emitting and p-type layers 104 formed on a region of the n-type layer 102, the region being other than that of the cathode electrode 103.

As a result of extensive studies by the inventors of the present application, they have found that the currently-used form of the LED package involves the following problems.

Both of "Wire Bonding type (W/B type)" and "Flip Chip type (F/C type)" need to connect the cathode and anode electrodes 103, 105 to a bonding wire 110 and/or a bump 120 on such electrodes, which requires a certain size or more of the electrodes so as to ensure the boding area 106. For example, the required size of the electrode can be about 100 µm by 100 µm in some cases. In particular, the size of the cathode electrode 103, which cannot contribute to the light-emitting area, is required. As such, the area for the anode electrode 105, which can contribute to the light-emitting area, is limited in the area of the LED chip, eventually preventing the chip area from being effectively used as a light-emitting area. This means that the current density can be adversely increased when the light emitting is provided with smaller-sized LED chip and/or the larger electric current, which leads to the lower luminous efficiency and the increased amount of the heat generation.

Particularly in the case of "Wire Bonding type (W/B type)", an active surface of the LED chip faces in a light-emitting direction, and thus an electrically-conductive transparent film is used as the anode electrode 105. However, a bonding pad 105' made of a metal film is required on a part of the anode electrode since a wire-bonding cannot be directly provided. Such bonding pad 105' can blocks the emitted light, and thereby the light extraction area of the LED is limited, which leads to a reduction of the amount of the light extraction. Furthermore, the wire itself can block the emitted light in the device of "Wire Bonding type (W/B type)", which also leads to a reduction of the amount of the light extraction.

The "Wire Bonding type (W/B type)" excels in terms of the heat-releasing performance since the back surface of the LED chip can be wholly connected to the substrate electrode 112, and also the thermal vias 113 can be provided directly under the LED chip. However, the active surface, which is regarded as a heat-generation source of the LED chip, faces upward. This causes the heat-releasing performance to be lowered due to the thermal resistance of the LED substrate 101 provided in a heat-releasing path located from the heat-generation source of the LED chip to a package substrate 111.

While on the other hand, the "Flip Chip type (F/C type)" excels in the light extraction from the LED chip because of the light emitting from the back surface of the LED substrate 101 and thus no light-blocking over the LED chip. However, the "Flip Chip type (F/C type)" is not necessarily preferable in view of the heat releasing because of the gold bump being the thermal resistance. More specifically, an area occupied by the gold bumps in the LED chip is small (for example, the occupied area is no more than about 25 % of the surface area of the LED chip when estimated at a maximum), and thus the gold bump unfavorably serves as a rate-determining part with respect to the heat dissipation, which leads to an insufficiency of the heat releasing through the substrate 121. Further, as for the package substrate 121, the heat-releasing performance in lateral direction through the substrate electrodes 122a, 122b disposed directly under the LED chip can be inhibited since the substrate electrodes 122a, 122b are required to be separated and insulated from each other serving as anode and cathode electrodes respectively, and also the thinner substrate is required. Furthermore, the higher flatness is required in the region of bump connection, and thus the thermal vias 123, which causes the lowering of the flatness, cannot be provided directly under the LED chip. This can also lead to an inhibition of the heat conduction through the region directly under the substrate.

The present invention has been created under the above circumstances. In other words, a main object of the present invention is to provide a light-emitting device capable of satisfying the both performances of the light extraction and the heat releasing.

### MEANS FOR SOLVING THE PROBLEM

Rather than addressing as merely extensions of conventional arts, the inventors tried to accomplish the above main object by addressing from a new point of view. As a result, the inventors have created the invention of the light-emitting device which is capable of achieving the above main object. As such, the present invention provides a light-emitting device comprising a light-emitting element, an element electrode, an extending-wiring electrode and a support,
wherein the light-emitting element is supported and secured by the support in such a form that a principal surface of the support and an active surface of the light-emitting element are flush with each other, and
wherein the extending-wiring electrode is in a surface contact with the element electrode such that the extending-wiring electrode extends beyond a periphery of the light-emitting element to the principal surface of the support, wholly covering the active surface of the light-emitting element.

One of the features of the light-emitting device according to the present invention is that not only the light-emitting element is supported and secured by the support in such a form the principal surface of the support and the active surface of the light-emitting element are approximately flush with each other, but also the extending-wiring electrode is in the surface contact with the element electrode such that the extending-wiring electrode largely extends beyond the periphery of the light-emitting element to the principal surface of the support, and thereby the active surface of the light-emitting element is wholly covered with the extending-wiring electrode.

The present invention also provides a package using the above device. Specifically, the present invention provides a light-emitting device package in which the light-emitting device is in a mounted state with respect to a mount substrate.

Furthermore, the present invention also provides a method for manufacturing a light-emitting device. Specifically, the present invention provides a method for manufacturing a light-emitting device comprising a light-emitting element, an element electrode, an extending-wiring electrode and a support, the method comprising the steps of:
(i) supporting and securing the light-emitting element by the support in such a form that a principal surface of the support and an active surface of the light-emitting element are approximately flush with each other;
(ii) forming the extending-wiring electrode such that the extending-wiring electrode makes a surface contact with the element electrode, and
wherein the forming of the extending-wiring electrode in the step (ii) is performed such that the formed extending-wiring electrode extends beyond a periphery of the light-emitting element to the principal surface of the support, wholly covering the active surface of the light-emitting element.

One of the features of the manufacturing method according to the present invention is that not only the supporting and securing of the light-emitting element by the support is performed in such a form that the principal surface of the support and the active surface of the light-emitting element are approximately flush with each other, but also the forming of the extending-wiring electrode is performed such that the extending-wiring electrode largely extends beyond the periphery of the light-emitting element to the principal surface of the support with the active surface of the light-emitting element being wholly covered with the extending-wiring electrode.

### EFFECT OF THE INVENTION

In accordance with the light-emitting device according to an embodiment of the present invention, the both performances of "light extraction" and "heat releasing" can be suitably provided.

Specifically, due to "extending-wiring electrode" reaching to the principal surface of the support, the element electrode substantially has such a form that it largely extends in a lateral direction, which leads to a suitable utilization of the outer periphery of the light-emitting element as a part of the element electrode. This means that a region (i.e., an area) of the light-emitting element can be effectively used as a light-emitting region. Furthermore, the package of the light-emitting device according to the present invention has a face-down structure where the electrode of the light-emitting element faces downward. This makes it possible to avoid such an inconvenience that "electrode on the upper side of the light-emitting element blocks light", which leads to the increase in the amount of the extracted light from the device.

In accordance with the present invention, a mounting with no bump is provided (that is, there is provided a mounting-less/bump-less device), and instead the extending-wiring electrode in the surface contact with the element electrode covers the active surface of the light-emitting element. This enables the heat from the light-emitting element to be released effectively. In this regard, the extending-wiring electrode can be made of a material with the high thermal conductivity (e.g., copper material), and also can be provided as "electrode part with its large thickness" and "electrode part with its large size in a width direction thereof". Therefore, the present invention makes it possible to effectively release the heat via the extending-wiring electrode to the outside thereof. Furthermore, the extending-wiring electrode has such a form that it is in direct contact with the active surface of the light emitting element (i.e., heat-generation source), which means that the heat-releasing path according to the present invention does not include a semiconductor substrate of the light-emitting element, and thus making it possible to directly release the heat from the heat source. It should be noted that the heat-releasing path according to the so-called "Wire Bonding type (W/B type)" includes the semiconductor substrate of the light-emitting element therein.

When focusing on the manufacturing method, the method according to an embodiment of the present invention enables the extending-wiring electrodes to be formed at a time with respect to a plurality of the light-emitting elements in a form of a direct wiring formation, which leads to provision of an advantageous effect of the higher productivity. It should be noted that a wire connection or flip-chip connection is performed for every single one of the light-emitting elements in the prior-art manufacturing of the package.

### BRIEF DESCRIPTION OF THE DRAWINGS

Fig. 1 is a cross-sectional view for schematically illustrating a configuration of a light-emitting device according to an embodiment of the present invention.
Figs. 2A and 2B are schematic top-plan and cross-sectional views for explaining a configuration of a light-emitting element used in a light-emitting device according to an embodiment of the present invention.
Fig. 3 includes schematic views for explaining "surface contact" according to an embodiment of the present invention.
Figs. 4A and 4B are schematic top-plan and cross-sectional views for explaining a configuration of a light-emitting device according to the first embodiment of the present invention.
Fig. 5 is a schematic cross-sectional view for explaining a configuration of a package wherein a light-emitting device according to the first embodiment of the present invention is in a mounted state with respect to a mount substrate.
Figs. 6A and 6B are schematic top-plan and cross-sectional views for explaining a configuration of a light-emitting device according to the second embodiment of the present invention.
Fig. 7 is a schematic cross-sectional view for explaining a configuration of a package wherein a light-emitting device according to the second embodiment of the present invention is in a mounted state with respect to a mount substrate.
Figs. 8A and 8B are process-cross sectional views schematically illustrating a manufacturing method according to an embodiment of the present invention.
Figs. 9A to 9G are process-cross sectional views schematically illustrating a manufacturing method according to the third embodiment of the present invention.
Fig. 10 is a schematic cross-sectional view for explaining an embodiment wherein a foundation layer with a relatively small average crystal grain size is formed by a dry plating process, and thereafter an extending-wiring electrode with a relatively large average crystal grain size is formed by a wet plating process.
Figs. 11A to 11F are process-cross sectional views schematically illustrating a manufacturing method according to the fourth embodiment of the present invention.
Fig. 12 is a perspective view for schematically illustrating an modified form of a frame body according to an embodiment of the present invention.
Figs. 13A to 13C are schematic cross-sectional and top-plan views for explaining a configuration of a LED chip and a LED package of the prior art.

### DETAILED DESCRIPTION OF THE INVENTION

A light-emitting device and a manufacturing method thereof according to an embodiment of the present invention will be hereinafter described in more detail. It should be noted that various parts or elements are schematically shown in the drawings wherein their dimensional proportions and their appearances are not necessarily real ones, and are merely illustrated for the purpose of making it easy to understand the present invention.

### [Light-emitting device of the present invention]

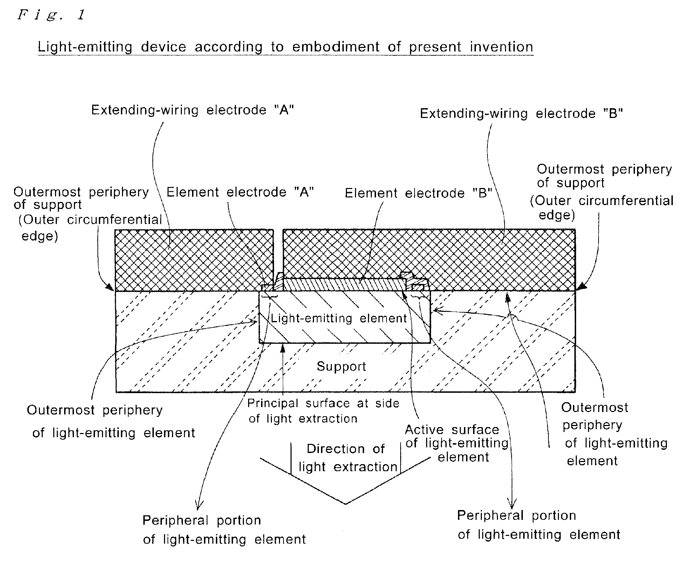

Fig. 1 schematically illustrates the configuration of the light-emitting device according to an embodiment of the present invention. As shown in Fig. 1, the light-emitting device according to an embodiment of the present invention comprises a light-emitting element, an element electrode, an extending-wiring electrode, and a support. The light-emitting element is supported and secured by the support in such a form that a principal surface of the support and an active surface of the light-emitting element are flush with each other. The extending-wiring electrode, which is in a surface contact with the element electrode, wholly covers the active surface of the light-emitting element, and extends beyond a periphery of the light-emitting element to the principal surface of the support.

The extending-wiring electrode in the light-emitting device according to an embodiment of the present invention is in a surface contact with the element electrode, and also the extending-wiring electrode largely protrudes from the light-emitting element in such a thick form that the extending-wiring electrode wholly covers the active surface corresponding to the back principal surface of the light-emitting element, the back principal surface being a light-extraction side of the device. As such, the extending-wiring electrode according to an embodiment of the present invention largely protrudes from the light-emitting element in a lateral direction such that the extending-wiring electrode is in the surface contact with the element electrode of the light-emitting element. This makes it possible to effectively release the heat from the light-emitting element via the extending-wiring electrode to the outside thereof. Such extending-wiring electrode (and also the element electrode being in the surface contact with the extending-wiring electrode), in spite of such form thereof, does not block the light extraction.

The term *"light-emitting device"* used herein encompasses not only a so-called "single-chip" device but also a "multi-chip" device, unless otherwise specified herein. Similarly, the light-emitting device according to an embodiment of the present invention encompasses not only "device exhibiting light directivity" but also "device exhibiting no light directivity", unless otherwise specified herein. The *"active surface"* used herein substantially refers to a surface contributing to an essential function of the light-emitting element. Specifically, the active surface corresponds to a surface of the light-emitting element where the element electrode is provided.

The term *"periphery"* used herein substantially refers to an local region of the light-emitting element, the local region being provided as an outer edge region of the light-emitting element. For example, term *"periphery"* means the local region located between an outermost edge of the light-emitting element and a 80 µm-inner point with respect to the outermost edge. From another viewpoint, term *"periphery"* according to an embodiment of the present invention corresponds to a region where the cathode element electrode is provided.

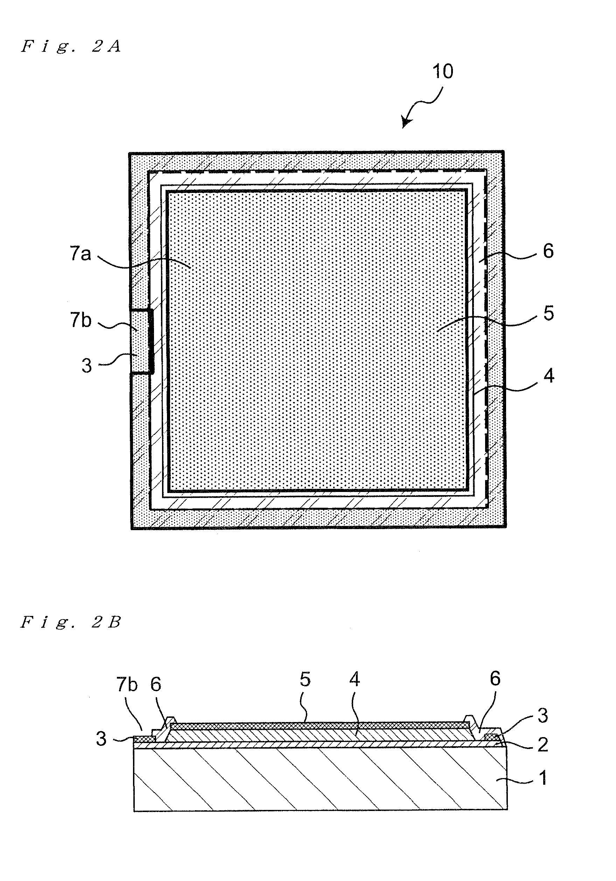

It is preferred in the light-emitting device that the element electrode is provided on the active surface such that it is located in at least a part of the periphery of the light-emitting element, as shown in Fig. 1. In other words, it is preferred that the element electrode is locally provided in the peripheral region of the light-emitting element, and also the element electrode is largely and widely provided in the inner region of the light emitting element, the inner portion being positioned inner with respect to the peripheral region of the light-emitting element. For example, the element electrode serving as a cathode electrode is provided in the peripheral region of the light-emitting element, whereas the element electrode serving as an anode electrode is provided in the inner region of the light-emitting element, the inner region is widely occupied in the area of the light-emitting element. The cathode electrode may extend along the whole periphery of the light-emitting element such that the anode electrode is surrounded by the cathode electrode. This means that the cathode electrode may have such a longitudinal form that it extends wholly at the peripheral region of the light-emitting element (see Fig. 2).

The configuration of the light-emitting element equipped with the anode and cathode electrodes is shown in Figs. 2A and 2B. Fig. 2A shows the top-plan view of the light-emitting element, and Fig. 2B shows the cross-sectional view of the light-emitting element. As for the light emitting element 10 as shown in Figs. 2A and 2B, a n-type layer 2 is formed on a LED substrate 1, and the element electrode 3 serving as the cathode electrode is formed on the periphery of the n-type layer 2. In the inner region with respect to the element electrode 3, a light-emitting layer and a p-type layer 4 are formed. The element electrode 5 serving as the anode electrode is formed thereon. It is preferred in the configuration of the light-emitting element that a passivation film 6 is formed largely in the surface of the light-emitting element such that opening portions 7a, 7b for contact with the element electrodes 3, 5 are provided in the passivation film. By way of example, the thickness of the light-emitting element 10 may be in the range of 60 µm to 140 µm (for example, about 100 µm), and the size of the light-emitting element 10 may be in the range of 0.4 mm by 0.4 mm to 0.8 mm by 0.8 mm (for example, about 0.6 mm by about 0.6 mm), which is smaller than that of the commonly-used light-emitting element with 1 mm by 1 mm. The term "*light-emitting element"* used in the present invention substantially means an element capable of emitting light. Examples of the light-emitting element include a light-emitting diode (LED) and an electronic component equipped therewith. Accordingly, the term *"light-emitting element"* in the present description means not only a "bare chip type LED (i.e., LED chip)" but also a "discrete type light-emitting element wherein a molding of the LED chip is provided". As the light-emitting element, not only the LED chip, but also a semiconductor laser chip may be used.

The element electrode will be described in more detail. The element electrode corresponds to an electrode of the light-emitting element. The material for the element electrode is not particularly limited, and thus may be typical one used for the conventional light-emitting diode (i.e., conventional LED). By way of example, the element electrode may be made of metal, and thus the element electrode may be a metal electrode. The thickness of the element electrode is not particularly limited, and thus may be typical one for the conventional light-emitting diode. By way of example, the thickness of the element electrode is preferably in the approximate range of 0.5 µm to 9 µm, more preferably in the approximate range of 1.0 µm to 5 µm, and most preferably in the approximate range of 1.5 µm to 3 µm (for example, about 2 µm).

In a case where the element electrode is composed of at least two parts, i.e., the cathode and anode electrodes, it is preferred that the extending-wiring electrodes are each separately in the contact with one of the parts of the element electrode. Namely, in a case where the element electrode is composed of at least two sub-electrodes (i.e., the cathode and anode electrodes), it is preferred that the extending-wiring electrodes are each separately in the contact with one of the sub-electrodes. More specifically, as shown in Fig. 1, the extending-wiring electrode "A" is provided such that it is in a surface contact with the cathode element electrode "A" which is locally positioned at the peripheral portion of the light-emitting element, and also the extending-wiring electrode "B" is provided such that it is in a surface contact with the anode element electrode "B" which is largely and widely provided in the inner principal region of the light-emitting element, the inner principal region being positioned inner with respect to the cathode.

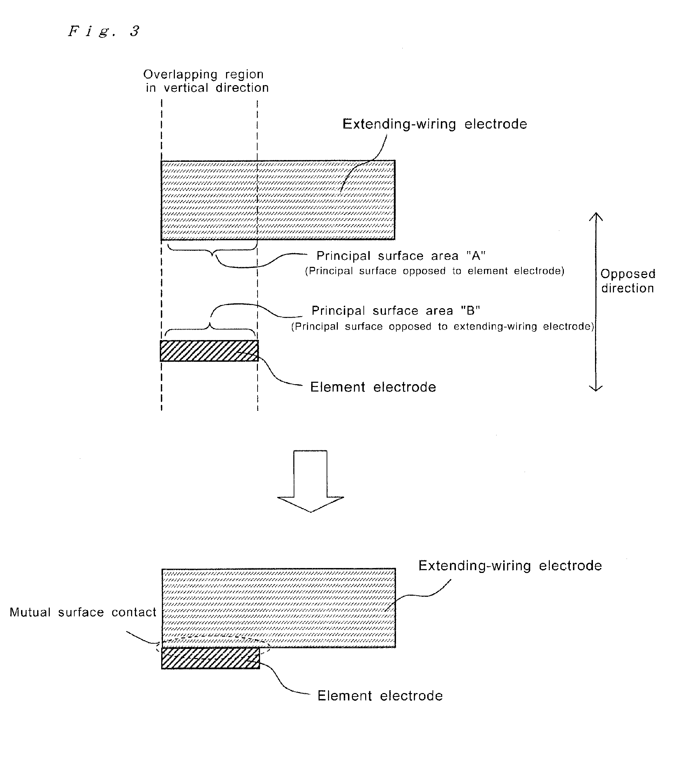

As describe above, the element electrode and the extending-wiring electrode are in the surface contact with each other. The term *"surface contact"* used herein means an embodiment wherein principal surfaces of respective ones of the part and element are contacted with each other, in particular an embodiment wherein overlapping regions between the opposed surfaces of the element electrode (especially, an exposed part thereof, i.e., element electrode part being exposed at the openings 7a,7b for contact) and the extending-wiring electrode are all contacted with each other. More specifically, the term *"surface contact"* means an embodiment wherein the overlapping regions between "surface of the element electrode (particularly, the exposed surface of the element electrode)" and "surface of the extending-wiring electrode" are all contacted or all bonded with each other. In other words, the term *"surface contact"* used herein means an embodiment wherein the mutual overlapping regions of connecting surfaces of the element electrode and the extending-wiring electrode are all contacted or all bonded, which corresponds to an embodiment shown in Fig. 3 where "principal surface area "A" and "principal surface area "B" are all contacted or all bonded with each other.

In the light-emitting device according to an embodiment of the present invention, the light-emitting element is supported and secured by the support in such a form that a principal surface of the support and an active surface of the light-emitting element are flush with each other, as shown in Fig. 1. Namely, the light-emitting element of the light-emitting device is supported and secured by the support while being flush with the support. The term *"supported and secured"* used herein substantially means an embodiment wherein the light-emitting element is held in the light-emitting device. More specifically, the term *"supported and secured"* used herein substantially means an embodiment wherein the light-emitting element is at least hold at its outermost periphery. This means that the light-emitting element is held at least by bonding or contacting of the outermost periphery thereof with the support. The material for the support is not particularly limited as long as it contributes to the supporting and securing of the light-emitting element. The support may be made of resin material or inorganic material. It is preferred that the support is made of a transparent resin in view of the light extraction. As such, the support may be preferably made of a transparent epoxy resin or a transparent silicone resin, for example.

In the light-emitting device according to an embodiment of the present invention, the principal surface of the support and the active surface of the light-emitting element are flush with each other. In other words, the principal surface of the support and the active surface of the light-emitting element are substantially on the same plane as each other. The term *"flush"* used herein means "substantially flush", does not necessarily means "exactly flush". In this regard, the term *"flush"* encompasses an embodiment wherein the difference in level between the principal surface of the support and the active surface of the light-emitting element is in the range of 0 to 10 µm (± 10 µm).

In the light-emitting device according to an embodiment of the present invention, the extending-wiring electrode is in the surface contact with the element electrode, and also the extending-wiring electrode largely protrudes from the light-emitting element, covering the whole of the active surface of the light-emitting element, as shown in Fig. 1. Due to the fact that the extending-wiring electrode largely protrudes in the lateral direction, the light-emitting device according to an embodiment of the present invention enables the heat from the light-emitting element to be released through such extending-wiring electrode to the outside thereof, which leads to an improved heat-releasing performance of the light-emitting device. For example, the extending-wiring electrode may extend such that it reaches an outermost periphery of the support. In other words, the extending-wiring electrode may longwise extend to the outermost edge of the support. Such longwise extending form of the extending-wiring electrode makes it possible to more effectively release the heat from the light-emitting element to the outside thereof. Similarly, the extending-wiring electrode may extend through a half or more of the periphery of the light-emitting element. In other words, the extending-wiring electrode may widely extend through the half or more of the periphery of the light-emitting element to the principal surface of the support. Such widely extending form of the extending-wiring electrode also makes it possible to more effectively release the heat from the light-emitting element to the outside thereof. As seen from such form of the extending-wiring electrode, the term "wholly covering" used herein substantially refers to an embodiment wherein the extending-wiring electrode has such a wide or large form that it covers the whole of the active surface of the light-emitting element.

A material for the extending-wiring electrode is not particularly limited as long as it mainly consists of metal. For example, at least one metal material selected from the group consisting of copper (Cu), silver (Ag), palladium (Pd), platinum (Pt) and nickel (Ni) can be used as a main material for the extending-wiring electrode. In a case where "heat releasing performance" is particularly regarded as important factor of the device, the extending-wiring electrode preferably comprises a metal material having a higher thermal conductivity than that of a solder material, for example. Assuming that the thermal conductivity of the solder material is for example in the range of about 45 W/mK to about 85 W/mK, the material of the extending-wiring electrode preferably has the higher thermal conductivity than about 45 W/mK to about 85 W/mK. The metal material having such higher thermal conductivity is copper (Cu) for example, and thus the extending-wiring electrode is preferably made of the copper.

In the light-emitting device according to an embodiment of the present invention, the extending-wiring electrode is preferably in a relatively thick form. It is particularly preferred that the extending-wiring electrode is thicker than the element electrode. The thick form of the extending-wiring electrode makes it possible to more effectively release the heat from the light-emitting element to the outside thereof. In other words, due to the fact that the extending-wiring electrode has such a large and thick form that it extends laterally and thus largely protrudes from the light-emitting element, the heat-releasing performance of the light-emitting device can be further improved. For example, it is preferred that the extending-wiring electrode has a thickness of 10 µm or more. More specifically, the thickness of the extending-wiring electrode is preferably in the approximate range of 10 µm to 500 µm, more preferably in the approximate range of 30 µm to 250 µm, and most preferably in the approximate range of 100 µm to 200 µm.

The light-emitting device according to an embodiment of the present invention can be used in a package wherein such device is in a mounted state on an electrode of a mount substrate. According to the prior art, the light-emitting element is mounted on a package substrate, followed by being mounted on a mount substrate. This is not true for an embodiment of the present invention. The package using the light-emitting device according to an embodiment of the present invention is characterized in that the extending-wiring electrode can be directly mounted with respect to the mount substrate without the package substrate, and thus the heat-releasing path has no package substrate therein.

The more specific embodiment of the light-emitting device of the present invention will be hereinafter described.

### (The First Embodiment)

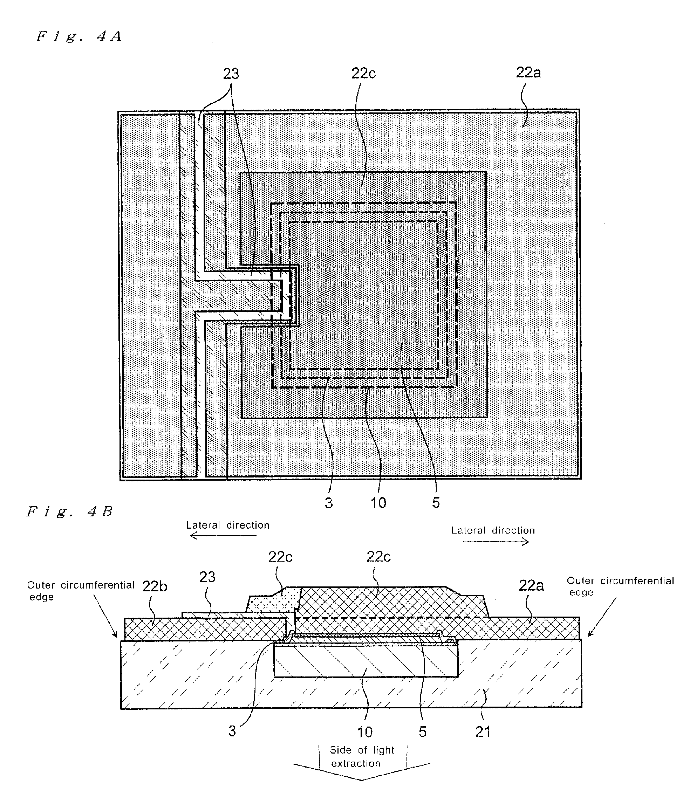

Fig. 4 schematically shows the configuration of the light-emitting device using the light-emitting element 10 shown in Fig. 2. Fig. 4A shows the top-plan view of the light-emitting device, and Fig. 4B shows the cross-sectional view of the light-emitting device. The light-emitting element 10 is supported and secured by side and back faces thereof being in an embedded state in the support 21 such that the active surface of the light-emitting element and the principal surface of the support 21 are substantially on the same plane as each other, the active surface corresponding to a front face of the device, and being provided with the light-emitting layer of the light-emitting element 10.

The support 21 is provided at the light extraction side of the light-emitting element 10. It is thus preferred that at least the light-emitting region of the support is made of optical resin (e.g., transparent epoxy resin or transparent silicone resin), optionally with fluorescent material included therein.

As seen from Figs. 4A and 4B, the extending-wiring electrodes 22a, 22b are situated on both of the active surface of the light-emitting element 10 and the principal surface of the support 21. As for the extending-wiring electrode 22a, it extends from the anode element electrode 5 of the light-emitting element 10 to the surrounding support 21. While on the other hand, as for the extending-wiring electrode 22b, it extends from the cathode element electrode 3 of the light-emitting element 10 to the surrounding support 21. According to the first embodiment, a convex portion 22c of the extending-wiring electrode is provided around the light-emitting element 10. In the boundary region between the extending-wiring electrodes 22a and 22b, an insulating film 23 (e.g., solder resist film) is provided so as to prevent an electrical short circuit upon mounting of the light-emitting device of the present invention by the solder material.

As such, the extending-wiring electrode laterally extends from the light-emitting element 10 (where at least a part of the element electrode is provided in the periphery thereof) through the periphery of the light-emitting element to the principal surface of the surrounding support 21. This means that there is no need for the conventional area for the wire-bonding or the bump formation, which makes it possible to make more effective use of the light-emitting area. The element electrode 3, which is provided at the peripheral region of the light-emitting element 10, not necessarily is located in the outermost periphery (i.e., outermost edge) of the light-emitting element 10. As required, the element electrode 3 may be provided such that it does not reach the outermost periphery (i.e., outermost edge) of the light-emitting element 10 so as not to cause the electrical short circuit. Alternatively, the element electrode 3 may be not provided in the whole of the outermost periphery (i.e., outermost edge) of the light-emitting element 10, but provided partially in at least a part of the outermost periphery (i.e., outermost edge) of the light-emitting element 10.

The material of the extending-wiring electrode preferably has a high thermal conductivity. For example, the material of the extending-wiring electrode may be a metal material with copper included therein. In consideration of the fact that the general resin material has the thermal conductivity of about 0.2 W/mK, and the copper material has an extremely high thermal conductivity of about 400 W/mK, the extending-wiring electrode made of metal with the copper included therein enables the heat from the light-emitting element 10 to diffuse in the lateral direction, improving the heat-releasing performance of the device. In this regard, the thickened extending-wiring electrode can effectively promote the diffusion of the heat in the lateral direction (i.e., in the direction perpendicular to the thickness direction of the element electrode). In order to provide the larger effect of the lateral heat diffusion, it is preferred that the extending-wiring electrode has the thickness of 10 µm or more, which is thicker than the thickness (e.g., a few micrometers) of the element electrode. The extending-wiring electrode may locally vary in its thickness such that an adjacent portion located adjacent to the light-emitting element (particularly, the adjacent portion corresponding to the electrode part positioned in the region of the active surface of the light-emitting element) is thicker than a surrounding portion located around the adjacent portion, the adjacent and surrounding portions being respectively parts of the extending-wiring electrode. The term *"adjacent portion located adjacent to the light-emitting element"* as used herein substantially means a part of the extending-wiring electrode, the part being positioned closer to the light-emitting element. For example, the adjacent portion located adjacent to the light-emitting element corresponds to a part of the extending-wiring electrode, the part being positioned to be overlapped with the light-emitting element. By way of example, the part 22a of the extending-wiring electrode may be a copper layer with its thickness of about 70 µm so as to improve the heat-releasing performance thereof, and whereas the convex part 22c of the extending-wiring electrode may be a copper layer with its thickness of about 30 µm. In other words, the extending-wiring electrode part located in the active surface region of the light-emitting element, i.e., the extending-wiring electrode part positioned to be overlapped with the LED chip may have the thickness of about 100 µm, whereas another extending-wiring electrode part positioned peripherally and outside with respect to the above extending-wiring electrode part may have the thickness of about 30 µm. The larger width dimension of the extending-wiring electrode, which width dimension occupies the periphery of the light-emitting element can provide an advantageous effect in terms of the lateral heat diffusion. In this regard, it is preferred that the extending-wiring electrode extends through a half or more of the whole periphery of the light-emitting element. The device as shown in Figs. 4A and 4B is configured such that the heat can diffuse through the approximately whole periphery of the light-emitting element 10.

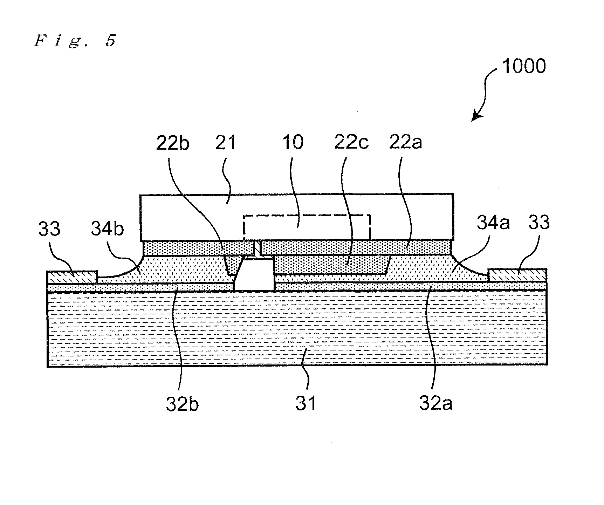

Fig. 5 schematically shows the configuration of the package in which the light-emitting device shown in Figs. 4A and 4B is in a mounted state with respect to a mount substrate. In Fig. 5, only the parts for the better understating of the present invention are shown. In this package, the extending-wiring electrodes 22a, 22b are in connection with substrate electrodes 32a, 32b provided on the mount substrate 31 via the solder parts 34a, 34b. Solder resist 33 is provided so as to prevent the wet-spreading of the solder parts. As shown in Fig. 5, the light-emitting device according to an embodiment of the present invention can be mounted directly with respect to the mount substrate without the package substrate 111 or 112 of the prior art (see Fig. 13), making it possible to release the heat from the light-emitting element 10 through the extending-wiring electrode and solder layer provided directly under the light-emitting element 10. Accordingly, in a case where the mount substrate 31 is a high heat-releasing substrate (for example, the mount substrate 31 is made of an aluminum nitride having the thermal conductivity of about 150 W/mK), a higher heat-releasing performance can be provided than that of the prior art. The use of Sn-based solder material for the package may lead to the lower thermal conductivity of about 50 W/mK. However, when the convex portion 22c of the extending-wiring electrode is provided directly under the light-emitting element, the solder layer 34, which is formed by the soldering, can be made thinner especially at its local region adjacent to the light-emitting element. This can prevent the heat-releasing performance attributed to the solder material from being adversely lower. Depending on the thickness of the convex portion 22c, the extending-wiring electrode may be in the close contact with the substrate electrodes 32a, 32b. By way of example, the thickness of the convex portion 22c can be about 30 µm in consideration of the fact that the particle size of the commonly-used solder paste is in the range of 20 µm to 30 µm. In this regard, the convex portion 22c can become close contact with the substrate electrode 32a by adjusting the amount of the solder, the thickness of the solder, the whole contacting area thereof, and thickness/area of the convex portion.

### (The Second Embodiment)

Next, the light-emitting device according to the second embodiment will be described wherein a frame body with a hole therein and a filler member provided in the hole are used.

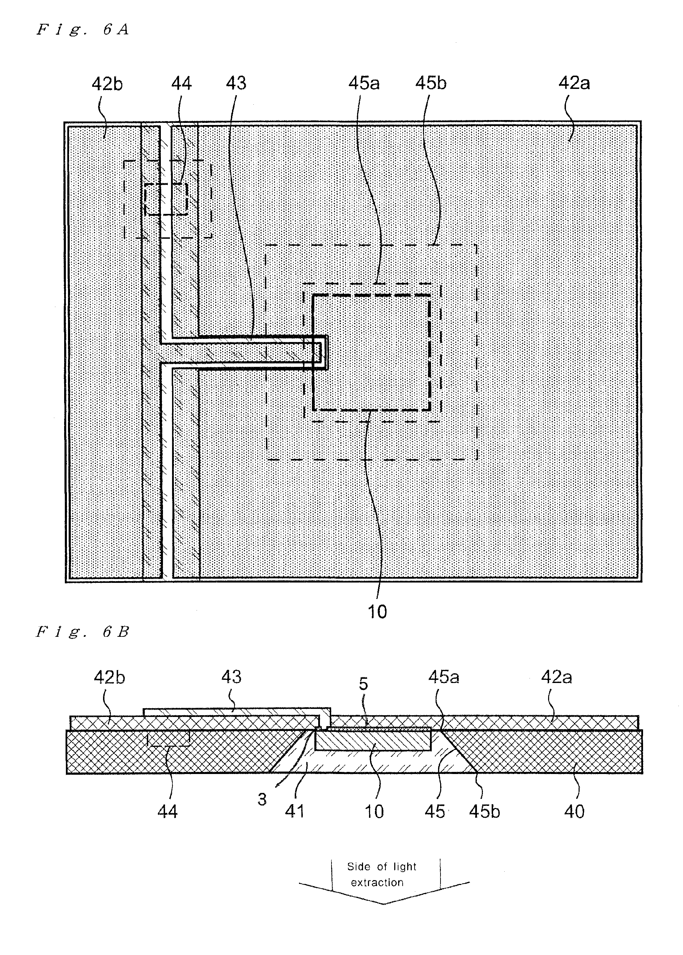

Figs. 6A and 6B schematically show the configuration of the light-emitting device according to the second embodiment. Fig. 6A shows the top-plan view of the light-emitting device, and Fig. 6B shows the cross-sectional view of the light-emitting device. In the light-emitting device according to the second embodiment, the light-emitting element 10 is located within the hole of the frame body 40, the active surface of the light-emitting element 10 corresponding to the front-side surface of the device. The void space between the frame body 40 and the light-emitting element 10 is filled with the filler material 41. The light-emitting element 10 is supported and secured by side and back faces thereof being in an embedded state in the filler material 41 such that the active surface of the light-emitting element 10 and the principal surfaces of the frame body 40 and the filler material are substantially on the same plane as each other. The light-emitting device according to the second embodiment can correspond to the device shown in Figs. 4A and 4B, in which case the periphery portion of the support 21 has been changed to the frame body 40. In this regard, the filler material 41 in the second embodiment may be made of the same optical resin as that of the support 21 used in the first embodiment.

The extending-wiring electrodes 42a, 42b are situated on both of the active surface of the light-emitting element 10 and the principal surfaces of the filler material 41 and the frame body 40. As for the extending-wiring electrode 42a, it extends from the anode element electrode 5 of the light-emitting element 10 to the surrounding filler material 41 and frame body 40. While on the other hand, as for the extending-wiring electrode 42b, it extends from the cathode element electrode 3 of the light-emitting element 10 to the surrounding filler material 41 and frame body 40. Furthermore, in the boundary region between the extending-wiring electrodes 42a and 42b, an insulating film 43 (e.g., solder resist film) is provided so as to prevent an electrical short circuit upon mounting of the light-emitting device of the present invention by the solder material.

According to the second embodiment, the extending-wiring electrode can laterally extend from the light-emitting element 10 (where at least a part of the element electrode is provided in the periphery thereof) through the periphery of the light-emitting element to the principal surfaces of the surrounding filler material 41 and frame body 40. The light-emitting device according to the second embodiment can provide the same advantageous effect as that of the device shown in Figs. 4A and 4B. This means that there is no need for the conventional area for the wire-bonding or the bump formation, which makes it possible to make more effective use of the light-emitting area.

Similarly to the embodiment wherein the light-emitting element 10 buried in the filler material 41 is in connection with the extending-wiring electrode, a Zener diode 44 in a buried form is in connection with the extending-wiring electrode. The Zener diode is preferably provided in the light-emitting device in that the risk of the breakage of the light-emitting element (e.g., LED element) attributed to the electrostatic discharge can be reduced.

Similarly to the case of the light-emitting device according to the first embodiment, the high thermal conductivity of the material for the extending-wiring electrode can improve the heat-releasing performance, the heat being attributed to the heat generation of the light-emitting element 10. In a case where the frame body 40 in the light-emitting device according to the second embodiment is made of high thermal conductivity material, e.g., the metal material with the copper included therein, the heat, which has diffused in the lateral direction by the extending-wiring electrode, can further diffuse to the wide and thick frame body 40. In other words, in a case where the extending-wiring electrode extends to the support body by which the light-emitting element is supported and secured, so-called "heat spreader function" can be provided wherein the heat from the light-emitting element can diffuse in the lateral direction via the extending-wiring electrode. The heat spreader function makes it possible to more effectively release the heat from the light-emitting element to the outside. Assuming that the frame body 40 made of the material having the high thermal conductivity has two to three times the thickness of that of the extending-wiring electrode, i.e., the frame body 40 has the thickness of about 180 µm to about 220 µm, the lateral heat diffusion can be achieved by more than three times of that of the extending-wiring electrode only, which makes it possible to largely improve the heat-releasing performance. The large size of the frame body 40 made of the high thermal conductivity material, which has approximately hundred times that of the light-emitting element (and thus it has the large size of about 5 mm by about 6 mm) can provide the larger area for releasing the heat to the mount substrate, which also makes it possible to greatly improve the heat-releasing performance. In terms of the heat-releasing of the filler material 41, it is effective to use the high thermal conductivity material for the frame body 40 wherein the heat-releasing path for cooling the filler material 41 through the frame body 40 can be ensured. This can also provide an advantageous effect in that the property degradation, which may be caused by the temperature rise attributed to the heat generation from the impaired fluorescent and optical resin materials, can be prevented.

When the electrically-conductive material (e.g., metal) is used as the material of the frame body 40, and the extending-wiring electrodes 42a, 42b are formed directly on the frame body 40, there is possibility that the electrical short circuit is caused between the extending-wiring electrodes 42a, 42b through the frame body 40. To avoid such short circuit, an insulating film can be provided on the surface of the frame body. For example, in a case where the copper is used as the base material of the frame body, a silicon oxide film or silicon nitride film may be preliminarily provided on the surface of the frame body, such surface is to be in contact at least with the extending-wiring electrodes 42a, 42b. It is preferred that the insulating film with insulating property is provided as a thin film having the thickness of about 5 µm or less since the resin material generally has the lower thermal conductivity. Alternatively, an inorganic insulating film may be used. Furthermore, in order to form the insulating film on the surface of the frame body, an alumite treatment may be performed wherein an aluminum oxide film is formed by an anode oxidation of the surface of the frame body whose base material is aluminum.

In a case where a hole wall 45 of the frame body 40 (i.e., hole surface by which the hole of the frame body is defined) has a wall surface with high reflectivity, the light emitted from the side face or back face of the light-emitting element 10 can be effectively reflected by the hole wall, which leads to an improved light extraction. In a case where the hole wall 45 of the frame body 40 is tapered such that the light-emitting-sided opening 45b is larger than the active surface-sided opening 45a, the light can be more effectively reflected toward the light-emitting side, which leads to the more improved light extraction. As the high-reflectivity material, at least one metal material selected from the group consisting of Ag (silver), Al (aluminum), Al alloy, Au (gold), Cr (chromium), Ni (nickel), Pt (platinum), Sn (Tin), Cu (copper), W (tungsten), Ti (titanium) and the like may be used. The film made of such high-reflectivity material may be provided on the surface of the frame body 40. Namely, an optical reflective layer may be provided on the wall surface of the hole.

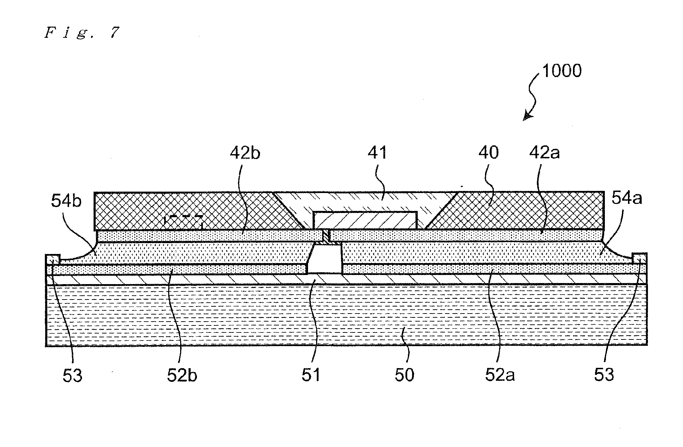

Fig. 7 schematically shows the configuration of the package in which the light-emitting device according to the second embodiment shown in Figs. 6A and 6B is in a mounted state with respect to a mount substrate. In Fig. 7, only the parts for the better understating of the present invention are shown. In this package, the extending-wiring electrodes 42a, 42b are in direct connection with substrate electrodes 52a, 52b provided on the mount substrate 50 by the solder parts 54a, 54b via the insulating layer 51. Solder resist 53 is provided so as to prevent the wet-spreading of the solder parts. Similarly to the package shown in Fig. 5, the light-emitting device according to an embodiment of the present invention can be mounted directly with respect to the mount substrate, making it possible to effectively release the heat.

In consideration of an aluminum-based substrate which is commonly used as a mount substrate for LED lightning, the package may have such a configuration that an aluminum is used as the base material of the mount substrate 50, the high heat-releasing resin is used as the insulating layer 51, and the thick copper foil as the substrate electrodes 52a, 52b is attached to the substrate 59. In spite of the high heat-releasing resin, such resin exhibits the lower thermal conductivity of at most 3 W/mk. As such, the large thickness (e.g., the thickness of about 70 µm) of the copper foil having the high thermal conductivity of 400 W/mK provides the thermal diffusion in the lateral direction, which enables the area of the insulating layer 51 to be larger, leading to the lower thermal resistance of the resin layer. In other words, the heat-releasing performance can be improved as a whole by the heat being released to the substrate whose base material is the aluminum with the high thermal conductivity of about 236 W/mK. In this package, the heat diffusion in the lateral direction can be effective such that the larger area located above insulating layer 51 is provided, the area being for contributing the heat-releasing, and thereby lowering the thermal resistance of the insulating layer 51. As for the package configuration shown in Fig. 7, the heat diffusion in the lateral direction can be not only provided by the substrate electrodes 52a, 52b, but also promoted by the thick extending-wiring electrode (which is much thicker than the substrate electrode) and frame body, making it possible to provide the much larger heat-releasing area for releasing the heat to the mount substrate, which leads to an improved heat-releasing performance.

As for the light-emitting device according to the second embodiment, the high-rigidity material can be used as the material of the frame body. The high-rigidity material of the frame body can improve the rigidity of the support which serves to support and secure the light-emitting element. This enhances the mechanical stability of the device when being mounted onto the mount substrate, especially the stability against the stress or thermal stress. In other words, the high rigidity material of the frame body can improve the reliability of the light-emitting device.

### [Manufacturing method of the present invention]

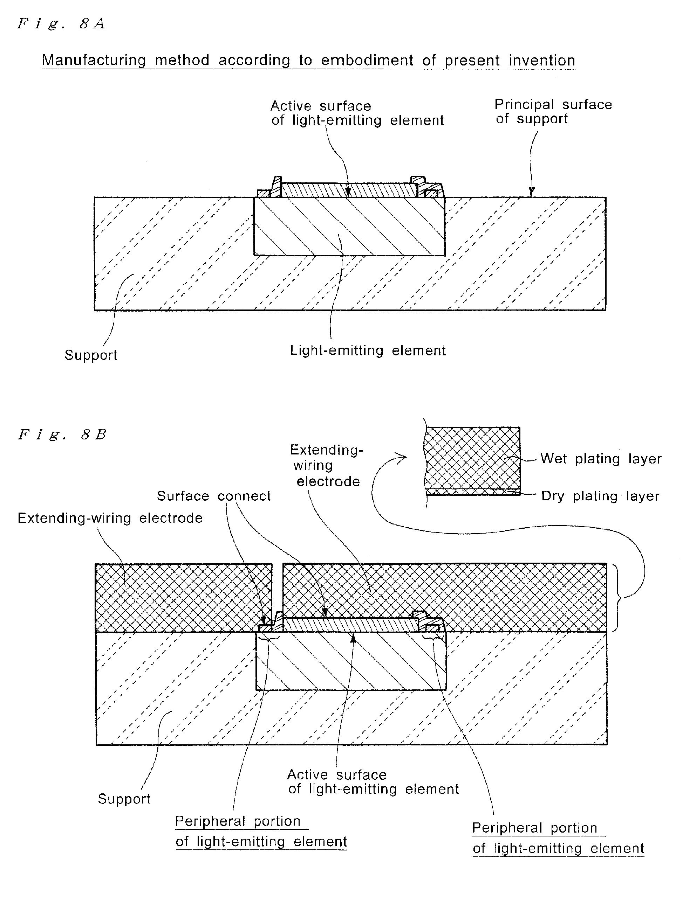

A method for manufacturing a light-emitting device according to an embodiment of the present invention will be described. In the manufacturing method according to an embodiment of the present invention, the step (i) is firstly carried out to support and secure a light-emitting element by a support so that a principal surface of the support and an active surface of the light-emitting element are flush with each other (see Fig. 8A). In this step, a carrier may be used. The supporting and securing of the light-emitting element by the support may be performed through the use of the carrier. Specifically, the light-emitting element is placed on an adhesive carrier, and thereafter the support is formed on the adhesive carrier such that the light-emitting element is surrounded by the formed support. Especially, the formation of the support is performed such that the formed support makes contact at least with the outer edge face of the light-emitting element. After the formation of the support, the adhesive carrier is peeled away to be removed. Through these substeps, the light-emitting element is supported and secured by the support.

Subsequent to the step (i), the step (ii) is carried out. Namely, the extending-wiring electrode is formed such that the extending-wiring electrode makes a surface contact with the element electrode. As shown in Fig. 8B, the forming of the extending-wiring electrode in the step (ii) is performed such that the formed extending-wiring electrode extends beyond a periphery of the light-emitting element to the principal surface of the support, wholly covering the active surface of the light-emitting element.

It is preferred that the formation of the extending-wiring electrode is performed by a plating process. In particular, it is preferred that the extending-wiring electrode is formed directly on the element electrode. A dry plating process and a subsequent wet plating process are preferably performed to form the extending-wiring electrode (see Fig. 8). These plating processes make it possible to form the extending-wiring electrode with larger width and thickness, such extending-wiring electrode being suitably used as a heat-releasing part. In particular, when focusing on the manufacturing processes, the plating layer by the wet plating process can be formed with being thick and having good adhesion due to the dry plating process.

Examples of the dry plating process include a vacuum plating process (Physical Vapor Deposition, i.e., PVD process) and a chemical vapor plating process (Chemical Vapor Deposition, i.e., CVD process). Examples of the vacuum plating process include a vacuum deposition process, a sputtering process, and an ion plating process. On the other hand, examples of the wet plating process include an electroplating process (e.g., electrolytic plating process), a chemical plating process, and a hot-dip plating process. In a preferred embodiment, the sputtering process may be performed as the dry plating process, and the electroplating process (e.g., electrolytic plating process) may be performed as the wet plating process. Preferably, the dry plating process is performed to form a dry plating layer with the thickness of 100 nm to 3000 nm (for example, the thickness of 100 nm to 2000 nm, the thickness of 100 nm to 1000 nm, or the thickness of 100 nm to 500 nm), and thereafter the wet plating process is performed to form a wet plating layer with the thickness of 10 µm to 500 µm, and thereby providing the extending-wiring electrode composed of the dry and wet plating layers. The dry plating layer is very thin, whereas the wet plating layer is thick. Due to the thick wet plating layer, the extending-wiring electrode can be formed with the large thickness as a whole.

The dry plating layer formed by the dry plating process comprises at least one kind of metal material selected from the group consisting of Ti (titanium), Cr (chromium) and Ni (nickel), for example. While on the other hand, the wet plating layer formed by the wet plating process comprises at least one kind of metal material selected from the group consisting of Cu (copper) and Al (aluminum), for example.

By way of example, the dry plating layer is not limited to a single layer, but may be formed as a form of multiple layers. For example, a Ti thin film layer and a Cu thin film layer may be formed as the dry plating layer. More specifically, the formation of the Ti thin film layer is performed, followed by the formation of the Cu thin film layer, the both formations being performed by the sputtering process. In this case, it is preferred that a thick Cu plating layer, i.e., the wet plating layer is formed by the electrolytic plating process on the sputtering layer having two-layered structure.

The plating layers provided by the dry and wet plating process are preferably subjected to a patterning process to have a desired form. Specifically, the extending-wiring electrode having such a form that it largely protrudes covering the active surface can be formed by the patterning process of the plating layers. In other words, the patterning treatment leads to a desired form of the extending-wiring electrode. The patterning in itself is not particularly limited as long as it is used in the electronics packaging field. For example, a photolithography process can be available for the patterning process, in which case a formation of resist layer, an exposure to the light and subsequent development, and an etching are sequentially performed.

The manufacturing method of the present invention will be described with reference to the more concrete embodiments.

### (The Third Embodiment)

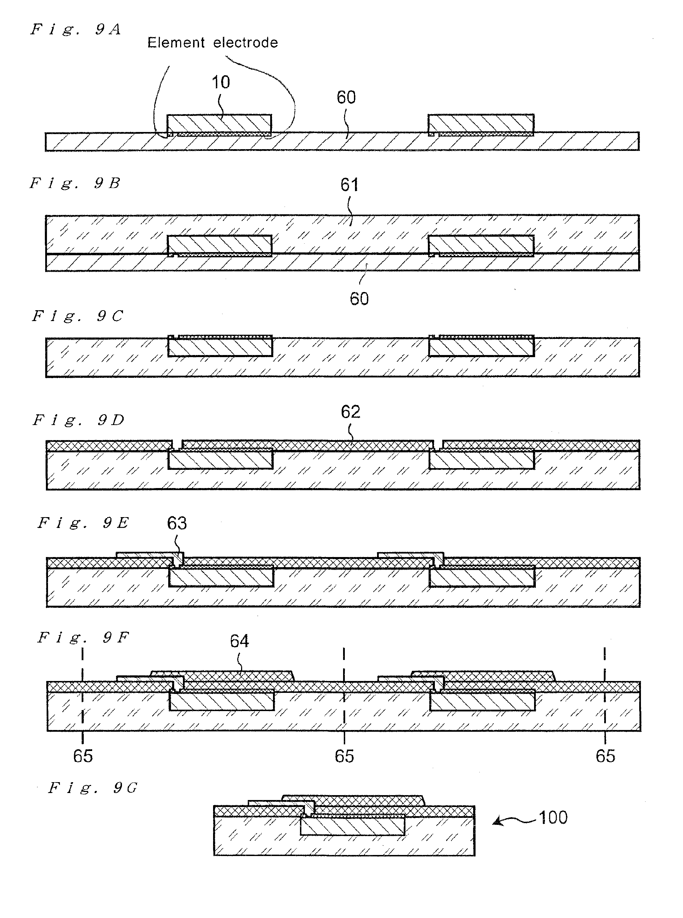

This embodiment corresponds to a method for manufacturing the light-emitting device according to the first embodiment. Figs. 9A-9G schematically illustrate processes associated with the manufacturing method according to the third embodiment of the present invention.

In the manufacturing method according to the third embodiment of the present invention, as shown in Fig. 9A, the active surface of the light-emitting element 10 is attached to a carrier plate 60. The light-emitting element 10 has an element electrode formed at the peripheral region thereof, and also another element electrode formed largely and widely at the inner region with respect to the peripheral region. The carrier plate 60 has a fixing property (e.g., adhesive property) in its surface on which the light-emitting element 10 is placed. Thus, the light-emitting element 10 is disposed onto the carrier plate 60 to achieve the fixing of the light-emitting element 10 on the carrier plate. An adhesive portion of the carrier plate is relatively soft, and thus the element electrodes are embedded into the adhesive portion upon the light-emitting element being disposed onto the carrier plate. As the carrier plate 60, a tape component with an adhesive thereon may be used.

Next, as shown in Fig. 9B, the outer edge of the light-emitting element 10 is embedded in the support 61, such outer edge being not attached to the carrier plate 60. Specifically, the light-emitting element 10 attached to the carrier plate 60 is coated with a transparent optical resin with fluorescence material included therein which is commonly used in the LED lightning, followed by being subjected to a heat-pressing process. As a result, there is provided the light-emitting element embedded in the transparent optical resin in a form of plate.

Next, as shown in Fig. 9C, the carrier plate 60 is peeled away for removal thereof. As the carrier plate 60 capable of being peeled away after the attaching of the light-emitting element and the formation of the support 61, the followings are available:
- Sheet capable of being peeled away by a foam generation attributed to the heat at a predetermined temperature;
- Sheet capable of being peeled away due to the lowered fixing property attributed to the cooling; and
- Sheet capable of being peeled away due to the curing of the adhesive material attributed to UV irradiation.
Through the steps as shown in Figs. 9A to 9C, the outer edge of the light-emitting element is supported and secured by the support 61 such that the principal surface of the support 61 and the active surface of the light-emitting element 10 are approximately on the same plane as each other.

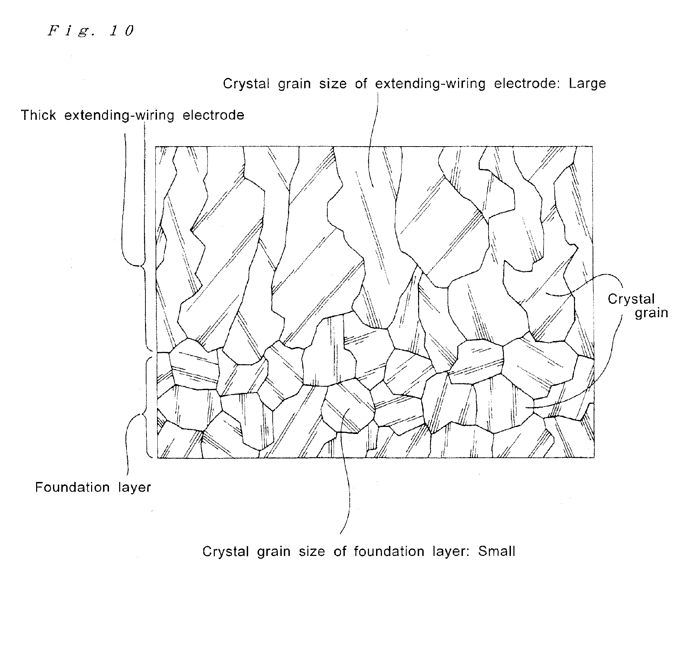

Subsequent to the supporting and securing of the light-emitting element, the extending-wiring electrode is formed. Specifically, as shown in Fig. 9D, the extending-wiring electrode 62 is formed on the active surface of the light-emitting element 10 and the principal surface of the support 61. A foundation layer for the formation of the extending-wiring electrode is formed on the whole of the active surface of the light-emitting element and the principal surface of the support, and thereafter the electroplating process (e.g., Cu plating) is performed by using the foundation layer as an electrode for the plating. Thereafter, the pattern-etching of the resulting plating layer and also the etching of the exposed foundation layer are performed, and thereby the thick extending-wiring electrode 62 is provided. A variety of plating processes can be available for the formation of the thick extending-wiring electrode. For example, the foundation layer is formed by the dry plating process, and then the thick extending-wiring electrode with its thickness being larger than that of the element electrode is formed by the wet plating process. Examples of the dry plating process include a vacuum plating process (Physical Vapor Deposition, i.e., PVD process) and a chemical vapor plating process (Chemical Vapor Deposition, i.e., CVD process). Examples of the vacuum plating process include a vacuum deposition process, a sputtering process, and an ion plating process. On the other hand, examples of the wet plating process include an electroplating process (e.g., electrolytic plating process), a chemical plating process, and a hot-dip plating process. In this regard, the foundation layer with a relatively small average crystal grain size is formed by the dry plating process, and thereafter the extending-wiring electrode with a relatively large average crystal grain size is formed by the wet plating process (see Fig. 10). In other words, the foundation layer with a relatively small average crystal grain size being smaller than that of the extending-wiring electrode is formed by the dry plating process, and thereafter the extending-wiring electrode with a relatively large average crystal grain size being larger than that of the foundation layer is formed by the wet plating process. The average crystal grain size of the foundation layer formed by the dry plating layer may be 2 µm or less, whereas the average crystal grain size of the extending-wiring electrode formed by the wet plating layer may be 5 µm or more. By way of example, the average crystal grain size of the foundation layer is in the range of 0 µm (excluding "0 µm") to 2 µm, whereas the average crystal grain size of the extending-wiring electrode is in the range of 5 µm to 20 µm. The term *"crystal grain size"* used herein means that a grain size calculated based on the cross-sectional image taken along the thickness direction of the extending-wiring electrode, as shown in Fig. 10. For example, the term *"crystal grain size"* means that a diameter of the circle having the same area as that of the crystal grain obtained from its cross-sectional image, and particularly the term *"average crystal grain size"* means the diameter calculated as a number average by measuring each grain diameter of 50 grains for example.

A so-called "semi-additive process" may be performed to form the extending-wiring electrode wherein a foundation is formed, and a photo resist layer is formed thereon, a plating growth is performed on no photo-resist region, and thereafter the resist and the exposed foundation layer are removed.

Next, as shown in Fig. 9E, an insulating film 63 is formed such that the formed film corresponds to the pattern of the extending-wiring electrode 62. The insulating film 63 is used for prevention of the electrical short between the extending-wiring electrodes upon the device being mounted onto the substrate. The insulating resin material for a solder resist may be used for the formation of the insulating film 63.

Next, as shown in Fig. 9F, an convex part 64 of the further extending-wiring electrode is formed in a way similar to the formation of the extending-wiring electrode 62.

Subsequent to the formation of the extending-wiring electrode, the dicing operation is performed. Namely, the precursor is divided into the separate devices by use of the dicing blade. Specifically, the cutting operation is conducted along the broken lines 65 as shown in Fig. 9E to provide the separate devices (see Fig. 9G).

Through the above, the characterizing process according to an embodiment of the present invention can be achieved wherein the outer edge of the light-emitting element is supported and secured by the support 61 such that the principal surface of the support 61 and the active surface of the light-emitting element 10 are approximately on the same plane as each other, and also the forming of the extending-wiring electrode 62 is performed such that the formed extending-wiring electrode 62 extends beyond the periphery of the light-emitting element 10 to the principal surface of the support 61, wholly covering the active surface of the light-emitting element 10. According to the present invention, there is no need to conduct the wire connection or flip-chip connection for every single one of the light-emitting elements (such connection being needed in the prior-art manufacturing of the package), and thus the direct formation of the extending-wiring electrodes with respect to a plurality of the light-emitting elements 10, and also the formation of the packages can be performed at a time.

### (The Fourth Embodiment)

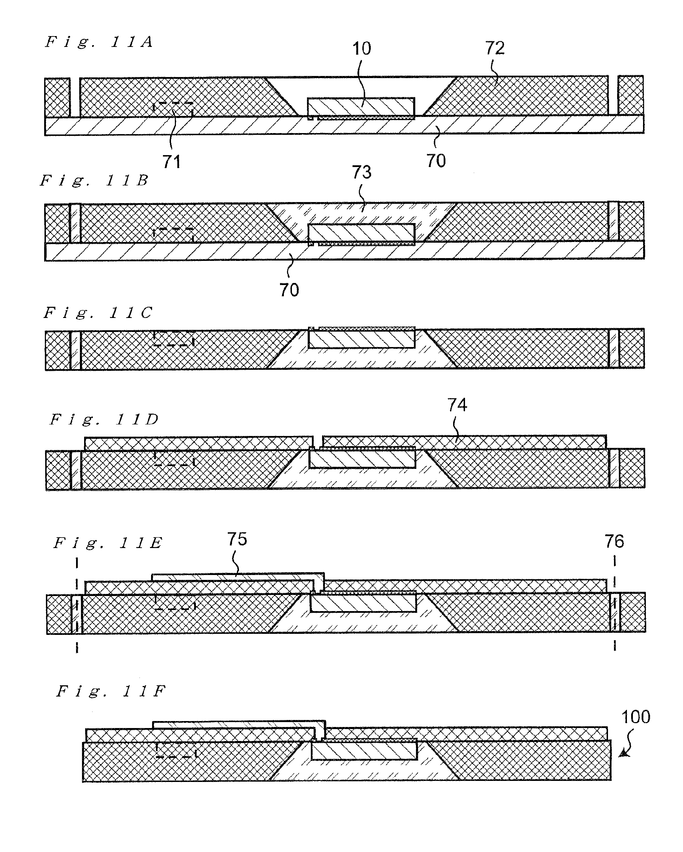

This embodiment corresponds to a method for manufacturing the light-emitting device according to the second embodiment. Figs. 11A-11F schematically illustrate processes associated with the manufacturing method according to the fourth embodiment of the present invention.

First, as shown in Fig. 11A, the light-emitting element 10 and the Zener diode 71 are placed onto the carrier plate 70 having the similar fixing property to that of the third embodiment. By so doing, the active surfaces of them are attached to the carrier plate 70. A frame body 72 with a hole is also placed onto the carrier plate 70, the hole being positioned at the placed light-emitting element and the Zener diode 71. The placing order of the light-emitting element, the Zener diode and the frame body is not particularly limited, and thus it can be determined in consideration of the productivity.

Next, as shown in Fig. 11B, the filling member 73 is formed wherein a void space of the hole of the frame body is filled with the filler material, the void space being formed as a hole space other than an occupying space of the light-emitting element and the Zener diode in the hole. The filling material may be the transparent optical resin which is similar to one used for the support in the third embodiment. Next, as shown in Fig. 11C, the carrier plate 70 is peeled away to be removed. Through the steps as shown in Figs. 11A to 11C, the light-emitting element 10 is embedded in the filler member 73, the outer edge of the light-emitting element 10 is supported and secured by the filling material 73 such that the active surface of the light-emitting element 10 and the principal surfaces of the frame body 72 and the filler member 73 are approximately on the same plane as each other.

Subsequent to the supporting and securing of the light-emitting element, the extending-wiring electrode is formed. Specifically, as shown in Fig. 11D, the extending-wiring electrode is formed on the active surface of the light-emitting element 10 and the principal surfaces of the frame body 72 and the filler member 73, similarly to that of the third embodiment. For example, the foundation layer is formed by the dry plating process, and then the thick extending-wiring electrode with its thickness being larger than that of the element electrode is formed by the wet plating process, similarly to that of the third embodiment. Namely, the foundation layer with a relatively small average crystal grain size being smaller than that of the extending-wiring electrode is formed by the dry plating process, and thereafter the extending-wiring electrode with a relatively large average crystal grain size being larger than that of the foundation layer is formed by the wet plating process.

Next, as shown in Fig. 11E, an insulating film 75 is formed such that the formed film corresponds to the pattern of the extending-wiring electrode 74, similarly to that of the third embodiment. Then, the cutting operation is conducted along the broken lines 76 as shown in Fig. 11E to provide the separate devices (see Fig. 11F). Specifically, the precursor is divided into the separate devices by use of the dicing blade.

Through the above, the characterizing process according to an embodiment of the present invention can be achieved wherein the outer edge of the light-emitting element 10 is supported and secured by the filler member 73 such that the principal surfaces of the frame body 72 and the filler member 73 (i.e., the support) and the active surface of the light-emitting element 10 are approximately on the same plane as each other, and also the forming of the extending-wiring electrode 74 is performed such that the formed extending-wiring electrode 74 extends beyond the periphery of the light-emitting element 10 to the principal surfaces of the frame body 72 and the filler member 73. According to the fourth embodiment, another characterizing process can be achieved wherein not only the light-emitting element, but also the Zener diode, i.e., the circuit components required for the light-emitting device can be built into the device.

It should be noted that the present invention as described above includes the following aspects:
The first aspect: A light-emitting device comprising a light-emitting element, an element electrode, an extending-wiring electrode (extraction electrode) and a support,
   wherein the light-emitting element is supported and secured by the support in such a form that a principal surface of the support and an active surface of the light-emitting element are flush with each other, and
   wherein the extending-wiring electrode is in a surface contact with the element electrode such that the extending-wiring electrode extends beyond a periphery of the light-emitting element to the principal surface of the support, wholly covering the active surface of the light-emitting element.
The second aspect: The light-emitting device according to the first aspect, wherein the element electrode is provided on the active surface, and the element electrode is located on at least a part of the periphery of the light-emitting element.
The third aspect: The light-emitting device according to the first or second aspect, wherein the extending-wiring electrode extends through a half or more of the periphery of the light-emitting element to the principal surface of the support.
The fourth aspect: The light-emitting device according to any one of the first to third aspects, wherein the extending-wiring electrode extends such that the extending-wiring electrode reaches an outermost periphery of the support.
The fifth aspect: The light-emitting device according to any one of the first to fourth aspects, wherein the extending-wiring electrode is thicker than the element electrode.
The sixth aspect: The light-emitting device according to the fifth aspect, wherein the extending-wiring electrode has a thickness of 10 µm or more.
The seventh aspect: The light-emitting device according to any one of the first to sixth aspects, wherein the extending-wiring electrode locally varies in its thickness such that an adjacent portion located adjacent to the light-emitting element is thicker than a surrounding portion located around the adjacent portion, the adjacent and surrounding portions being respectively parts of the extending-wiring electrode.
The eighth aspect: The light-emitting device according to any one of the first to seventh aspects, wherein the element electrode is composed of at least two parts, and
   the extending-wiring electrode is provided in plurality form, and the extending-wiring electrodes are each separately in the surface contact with one of the parts of the element electrode.
The ninth aspect: The light-emitting device according to any one of the first to eighth aspects, wherein the extending-wiring electrode comprises a metal material having a higher thermal conductivity than that of a solder material.
The tenth aspect: The light-emitting device according to any one of the first to ninth aspects, wherein the support is at least composed of a frame body with a hole therein and a filler member provided in the hole, and
   wherein the light-emitting element is located within the filler member such that the light-emitting element is flush with the frame body.
The eleventh aspect: The light-emitting device according to the tenth aspect, wherein a hole surface by which the hole of the frame body is defined is an optical reflective surface.
The twelfth aspect: The light-emitting device according to the eleventh aspect, wherein the optical reflective surface is a tapered surface.
The thirteenth aspect: The light-emitting device according to any one of the tenth to twelfth aspects, wherein the extending-wiring electrode extends such that at least a part of the extending-wiring electrode reaches the frame body.
The fourteenth aspect: The light-emitting device according to any one of the tenth to thirteenth aspects, wherein the frame body comprises a metal material.
The fifteenth aspect: A light-emitting device package, comprising the light-emitting device according to any one of the first to fourteenth aspects, the device being in a mounted state with respect to a mount substrate.
The sixteenth aspect: A method for manufacturing a light-emitting device comprising a light-emitting element, an element electrode, an extending-wiring electrode and a support, the method comprising the steps of:
   (i) supporting and securing the light-emitting element by the support in such a form that a principal surface of the support and an active surface of the light-emitting element are flush with each other; and
   (ii) forming the extending-wiring electrode such that the extending-wiring electrode makes a surface contact with the element electrode of the light-emitting element,
   wherein the forming of the extending-wiring electrode in the step (ii) is performed such that the formed extending-wiring electrode extends beyond a periphery of the light-emitting element to the principal surface of the support, wholly covering the active surface of the light-emitting element.
The seventeenth aspect: The method according to the sixteenth aspect, wherein the step (i) comprises the sub-steps of:
   (i)' placing the light-emitting element on an adhesive carrier;
   (i)" forming the support on the adhesive carrier such that the light-emitting element is surrounded by the support, and thereby providing a precursor of the light-emitting device; and
   (i)"' removing the adhesive carrier from the precursor.
The eighteenth aspect: The method according to the seventeenth aspect, wherein, as the support, a frame body with a hole therein and a filler member located in the hole are provided on the adhesive carrier, and
   wherein the placing of the light-emitting element and the provision of the frame body are performed such that the light-emitting element is positioned within the hole of the frame body, and the filling member is formed in a void space of the hole, the void space being provided as a hole space other than an occupying space of the light-emitting element in the hole.
The nineteenth aspect: The method according to any one of the sixteenth to eighteenth aspects, wherein not only the light-emitting element, but also an electronic component for the light-emitting device is supported and secured by the support in the step (i).
The twentieth aspect: The method according to any one of the sixteenth to nineteenth aspects, wherein a dry plating process and a subsequent wet plating process are performed in the step (ii) to form the extending-wiring electrode with a larger thickness than that of the element electrode.

While some embodiments of the present invention have been hereinbefore described, they are merely the typical embodiments. It will be readily appreciated by those skilled in the art that the present invention is not limited to the above embodiments, and that various modifications are possible without departing from the scope of the present invention.

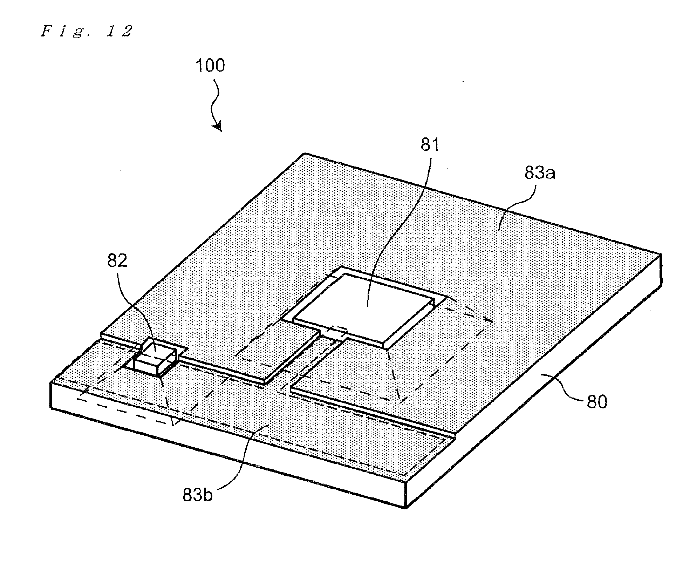

In the light-emitting device as shown in Figs. 6A and 6B, the insulating film is provided on the frame body 40 so as to avoid the electrical short circuit between the extending-wiring electrodes 42a and 42b via the frame body 40. The present invention is not limited to this. The frame body as shown in Fig. 12 may also be used to avoid the electrical short circuit.

Fig. 12 is a perspective view for illustrating an example of the frame body used for the light-emitting device of the present invention. Similarly to the frame body of Figs. 6A and 6B, the frame body 80 has holes for the positions of the light-emitting element 81 and the Zener diode 82. The extending-wiring electrodes 83a and 83b are provided on the surface of the frame body 80. In this regard, the local surface region of the frame body 80 for the extending-wiring electrode 83b is a concave surface region. This concave surface region can be easily formed by an etching process performed with respect to the principal surface of the frame body made of copper. The filling material may be provided between the extending-wiring electrode 83b and the concave surface region of the frame body 80 to ensure the insulating properties therebetween, while providing the supporting and securing properties, in which case the concave dimension and the fluidity of the filling material are suitably adjusted. In the case of the poor thermal conductivity of the filling material, the extending-wiring electrode 83a, which can contribute to the lateral diffusion of the heat from the light-emitting element, may be in direct contact with the frame body 80, and while on the other hand, the extending-wiring electrode 83b may have the insulating structure, as shown in Fig. 12.

### INDUSTRIAL APPLICABILITY

The light-emitting device according to an embodiment of the present invention can be suitably used not only for various types of lighting applications, but also for a wide range of applications such as backlight source applications for display device (particularly for liquid crystal display), camera flash applications, and automotive applications.

### CROSS REFERENCE TO RELATED PATENT APPLICATION

The present application claims the right of priority of Japan patent application No. 2012-235379 (filing date: October 25, 2012, title of the invention: LIGHT-EMITTING DEVICE, METHOD FOR MANUFACTURING THE SAME AND LIGHT-EMITTING DEVICE PACKAGE), the whole contents of which are incorporated herein by reference.

### EXPLANATION OF REFERENCE NUMERALS

- 1: LED substrate
- 2: n-type layer
- 3: Element electrode (cathode electrode)
- 4: Light-emitting layer and p-type layer
- 5: Element electrode (anode electrode)
- 6: Passivation film
- 7a, 7b: Opening portion
- 10: Light-emitting element
- 21: Support (e.g., optical resin support)
- 22a, 22b, 22c, 44a, 44b: Extending-wiring electrode
- 23, 43: Insulating film (e.g., solder resist)
- 31, 50: Mount substrate
- 40: Frame body
- 41: Filler member/material (e.g., optical resin member)
- 60, 70: Carrier plate
- 100: Light-emitting device
- 1000: Light-emitting device package

## Claims

1. A light-emitting device comprising a light-emitting element, an element electrode, an extending-wiring electrode and a support,
wherein the light-emitting element is supported and secured by the support in such a form that a principal surface of the support and an active surface of the light-emitting element are flush with each other, and
wherein the extending-wiring electrode is in a surface contact with the element electrode such that the extending-wiring electrode extends beyond a periphery of the light-emitting element to the principal surface of the support, wholly covering the active surface of the light-emitting element.

2. The light-emitting device according to claim 1,
wherein the element electrode is provided on the active surface such that the element electrode is located on at least a part of the periphery of the light-emitting element.

3. The light-emitting device according to claim 1,
wherein the extending-wiring electrode extends through a half or more of the periphery of the light-emitting element to the principal surface of the support.

4. The light-emitting device according to claim 1,
wherein the extending-wiring electrode extends such that the extending-wiring electrode reaches an outermost periphery of the support.

5. The light-emitting device according to claim 1,
wherein the extending-wiring electrode is thicker than the element electrode.

6. The light-emitting device according to claim 5,
wherein the extending-wiring electrode has a thickness of 10 µm or more.

7. The light-emitting device according to claim 1,
wherein the extending-wiring electrode locally varies in its thickness such that an adjacent portion located adjacent to the light-emitting element is thicker than a surrounding portion located around the adjacent portion, the adjacent and surrounding portions being respectively parts of the extending-wiring electrode.

8. The light-emitting device according to claim 1,
wherein the element electrode is composed of at least two parts, and
the extending-wiring electrodes are each separately in the surface contact with one of the parts of the element electrode.

9. The light-emitting device according to claim 1,
wherein the extending-wiring electrode comprises a metal material having a higher thermal conductivity than that of a solder material.

10. The light-emitting device according to claim 1,
wherein the support is at least composed of a frame body with a hole therein and a filler member provided in the hole, and
wherein the light-emitting element is located within the filler member such that the light-emitting element is flush with the frame body.

11. The light-emitting device according to claim 10,
wherein a hole surface by which the hole of the frame body is defined is an optical reflective surface.

12. The light-emitting device according to claim 11,
wherein the optical reflective surface is a tapered surface.

13. The light-emitting device according to claim 10,
wherein the extending-wiring electrode extends such that at least a part of the extending-wiring electrode reaches the frame body.

14. The light-emitting device according to claim 10,
wherein the frame body comprises a metal material.

15. A light-emitting device package, comprising the light-emitting device according to claim 1, the device being in a mounted state with respect to a mount substrate.

16. A method for manufacturing a light-emitting device comprising a light-emitting element, an element electrode, an extending-wiring electrode and a support, the method comprising the steps of:
(i) supporting and securing the light-emitting element by the support in such a form that a principal surface of the support and an active surface of the light-emitting element are flush with each other; and
(ii) forming the extending-wiring electrode such that the extending-wiring electrode makes a surface contact with the element electrode of the light-emitting element,
wherein the forming of the extending-wiring electrode in the step (ii) is performed such that the formed extending-wiring electrode extends beyond a periphery of the light-emitting element to the principal surface of the support, wholly covering the active surface of the light-emitting element.

17. The method according to claim 16, wherein the step (i) comprises the sub-steps of:
(i)' placing the light-emitting element on an adhesive carrier;
(i)" forming the support on the adhesive carrier such that the light-emitting element is surrounded by the support, and thereby providing a precursor of the light-emitting device; and
(i)"' removing the adhesive carrier from the precursor.

18. The method according to claim 17, wherein, as the support, a frame body with a hole therein and a filler member located in the hole are provided on the adhesive carrier, and
wherein the placing of the light-emitting element and the provision of the frame body are performed such that the light-emitting element is positioned within the hole of the frame body, and the filling member is formed in a void space of the hole, the void space being provided as a hole space other than an occupying space of the light-emitting element in the hole.

19. The method according to claim 16, wherein not only the light-emitting element, but also an electronic component for the light-emitting device is supported and secured by the support in the step (i).

20. The method according to claim 16, wherein a dry plating process and a subsequent wet plating process are performed in the step (ii) to form the extending-wiring electrode with a larger thickness than that of the element electrode.
